# EUROPEAN PATENT APPLICATION

(11) **EP 4 835 610 A1**
(43) Date of publication of application: **04.11.2026**
(21) Application number: 25205297.2
(22) Date of filing: 29.09.2025
(51) Int. Cl.: G06F 1/188

(54) **COMPUTER HOST COMPRISING A POWER SUPPLY UNIT**

(30) Priority: 29.04.2025 TW 114204286 U
(71) Applicant: ASUSTeK Computer Inc., Peitou, Taipei (TW)
(72) Inventor: YANG, Yu-Sheng, TAIPEI (TW); HUANG, Kuo-Chen, TAIPEI (TW); LIN, Zheng-Wei, TAIPEI (TW)
(74) Representative: Viering, Jentschura & Partner mbB Patent- und Rechtsanwälte

(57) **Abstract**

A computer host (10) includes a chassis (11), a main board (12), and a power supply (13). The power supply (13) is arranged in the chassis (11), and includes a power circuit board (132) with a first side edge (R1) and a second side edge (R2), an alternating current (AC) input port (134), a first direct current (DC) output port (136), and a conversion circuit (138). The AC input port (134) is provided on the first side edge (R1), and is exposed to outside of the chassis (11) through a power opening (112). The first DC output port (136) is provided on the second side edge (R2), and is electrically connected to the main board (12). A direction of an opening of the first DC output port (136) is parallel to a surface of the power circuit board (132). The conversion circuit (138) is arranged on the power circuit board (132), and is adapted to convert an AC voltage received by the AC input port (134) into a DC voltage provided to the first DC output port (136).

## Description

### CROSS-REFERENCE TO RELATED APPLICATION

This application claims the priority benefit of Taiwan Application Serial No. 114204286, filed on April 29, 2025. The entirety of the above-mentioned patent application is hereby incorporated by reference herein and made a part of specification.

### BACKGROUND OF THE INVENTION

### Field of the Invention

The disclosure relates to an electronic device, and in particular, to a computer host provided with a power supply.

### Description of the Related Art

A computer host, such as a desktop computer, a workstation, and a server, is provided with a power supply, which is configured to convert alternating current (AC) mains supply into direct current (DC) power for use by a computer system inside the computer case.

An architecture of a conventional power supply mainly includes a power circuit board and an output circuit board. The power circuit board is configured to convert power between AC and DC. The output circuit board is fixed to the power circuit board by soldering, and the output circuit board is provided with an output connector for external power supply. The architecture requires not only the output connector to be soldered and fixed to the output circuit board, but also the output circuit board to be soldered and fixed to the power circuit board, which is a complicated assembly process. In addition, to ensure that an internal board of the power supply is structurally stable, the power circuit board and the output circuit board are further required to be fixed to a housing of the power supply by means of screw locking, which increases additional labor costs.

### BRIEF SUMMARY OF THE INVENTION

The disclosure provides a computer host. The computer host includes a chassis, a main board, and a power supply. The chassis includes a power opening. The main board is arranged in the chassis. The power supply is arranged in the chassis, and includes a power circuit board, an alternating current (AC) input port, a first direct current (DC) output port, and a conversion circuit. The power circuit board includes a first side edge and a second side edge. The AC input port is provided on the first side edge of the power circuit board and exposed to outside of the chassis through the power opening. The first DC output port is provided on the second side edge of the power circuit board, and is electrically connected to the main board through a first power line (142). A direction of an opening of the first DC output port is parallel to a surface of the power circuit board. The conversion circuit is arranged on the power circuit board and electrically connected to the AC input port and the first DC output port, and is adapted to convert an AC voltage received by the AC input port into a first DC voltage provided to the first DC output port.

Compared to prior art, the disclosure has the following advantages. Firstly, the first DC output port of the power supply in the disclosure is directly fixed to the power circuit board by soldering, which helps reduce materials and assembly procedures, thereby improving reliability of power output. Secondly, the assembly manner of the first DC output port is applicable to an existing surface mount technology (SMT) process, which helps save labor costs and improve production efficiency.

### BRIEF DESCRIPTION OF THE DRAWINGS

FIG. 1A and FIG. 1B are schematic diagrams of a computer host according to an embodiment of the disclosure.
FIG. 2A and FIG. 2B are schematic diagrams of a power supply according to an embodiment of the disclosure.
FIG. 3A and FIG. 3B are schematic diagrams of a first direct current (DC) output port according to an embodiment of the disclosure.
FIG. 4 is a schematic diagram of a second DC output port according to an embodiment of the disclosure.
FIG. 5 is a schematic diagram of a power supply according to another embodiment of the disclosure.
FIG. 6 is a schematic diagram of a power supply according to yet another embodiment of the disclosure.

### DETAILED DESCRIPTION OF THE EMBODIMENTS

Specific embodiments of the disclosure are described in more details below with reference to the schematic diagrams. Advantages and features of the disclosure are to be clearer based on the following descriptions and claims. It is to be noted that all of the figures are in a very simple form and in an inaccurate proportion, and are merely intended to assist description of the purpose of the embodiments of the disclosure conveniently and clearly.

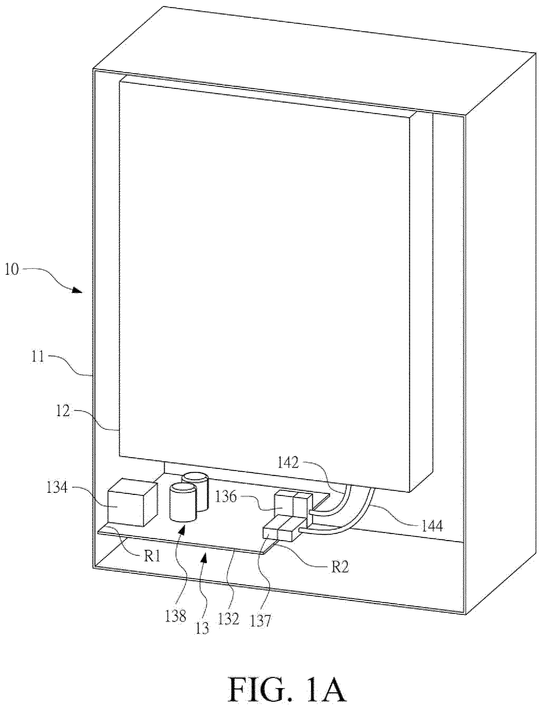

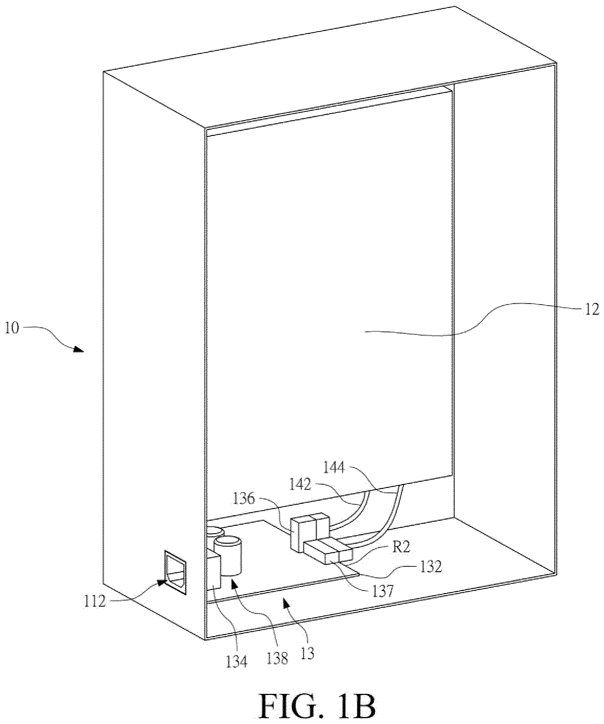

FIG. 1A and FIG. 1B are partial schematic diagrams of a computer host 10 according to an embodiment of the disclosure.

As shown in the figures, the computer host 10 includes a chassis 11, a main board 12, and a power supply 13.

The main board 12 and the power supply 13 are arranged in the chassis 11. A power opening 112 is provided near a bottom of a rear panel of the chassis 11, to facilitate input of mains supply (alternating current (AC) power). Based on different arrangement positions of the power supply 13 in the chassis 11, the power opening 112 is alternatively arranged at another position of the chassis 11.

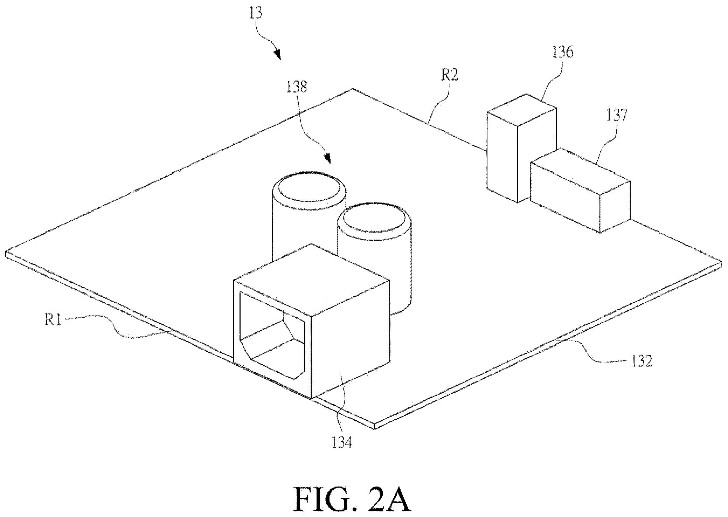

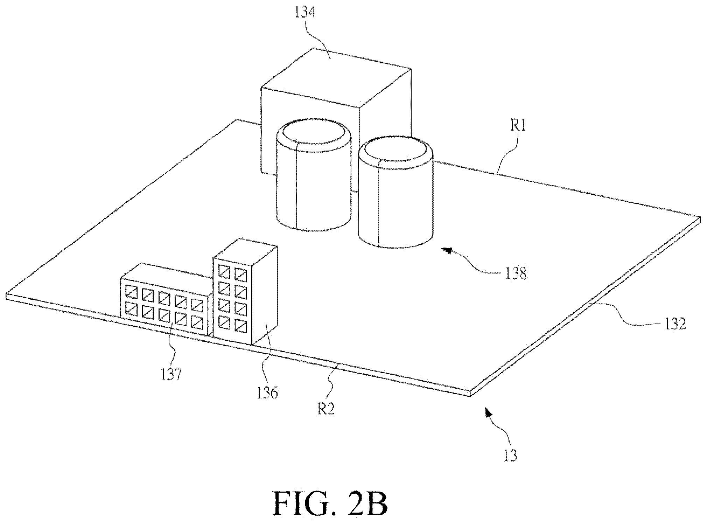

Referring to FIG. 2A and FIG. 2B additionally, FIG. 2A and FIG. 2B are schematic diagrams of a power supply 13 according to an embodiment of the disclosure.

As shown in the figures, the power supply 13 includes a power circuit board 132, an AC input port 134, a first direct current (DC) output port 136, and a conversion circuit 138 (two capacitors are depicted in the figures for illustration, and a circuit layout is formed on the power circuit board 132 based on an actual requirement).

In an embodiment, the power supply 13 includes a housing (not shown in the figures). The power circuit board 132, the AC input port 134, the first DC output port 136, and the conversion circuit 138 described above are all located inside the housing. The power circuit board 132 is fixed in the housing by means of screw locking or engagement.

The power circuit board 132 includes a first side edge R1 and a second side edge R2. The AC input port 134 is provided on the first side edge R1 of the power circuit board 132. The first side edge R1 abuts against the rear panel of the chassis 11. The AC input port 134 is adapted to be exposed to outside of the chassis 11 through the power opening 112 on the rear panel.

The first DC output port 136 is provided on the second side edge R2 of the power circuit board 132. The first DC output port 136 is electrically connected to the main board 12 through a first power line (142) 142. A direction of an opening (or an insertion direction) of the first DC output port 136 is parallel to a surface of the power circuit board 132, and an outer edge of the opening of the first DC output port 136 is flush with the second side edge R2.

In this embodiment, the first side edge R1 and the second side edge R2 are two opposite side edges of the power circuit board 132. In another embodiment, the first side edge R1 and the second side edge R2 are also two adjacent side edges of the power circuit board 132.

In an embodiment, as shown in the figures, the power supply 13 further includes a second DC output port 137. A structure of the second DC output port 137 is different from that of the first DC output port 136. The second DC output port 137 is also provided on the second side edge R2 of the power circuit board 132, and is electrically connected to the main board 12 through a second power line 144. In an embodiment, as shown in the figures, the first DC output port 136 and the second DC output port 137 are arranged side by side on the second side edge R2 of the power circuit board 132.

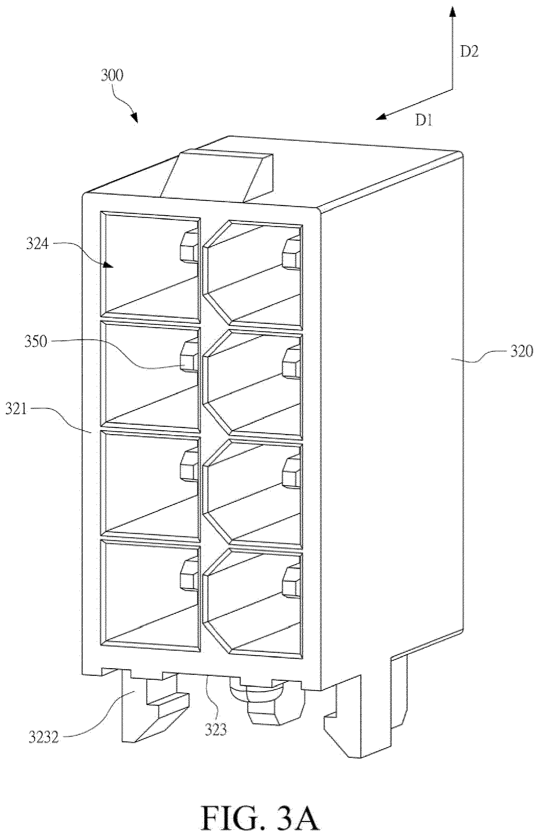

Similar to the first DC output port 136, a direction of an opening (or an insertion direction) of the second DC output port 137 is parallel to the surface of the power circuit board 132, and an outer edge of the opening of the second DC output port 137 is flush with the second side edge R2. A detailed description of the structures of the first DC output port 136 and the second DC output port 137 is provided in detail in the paragraphs corresponding to FIG. 3A to FIG. 4 below.

The conversion circuit 138 is arranged on the power circuit board 132, and is electrically connected to the AC input port 134, the first DC output port 136, and the second DC output port 137. The conversion circuit is adapted to convert the AC voltage received by the AC input port 134 into a first DC voltage provided to the first DC output port 136, and to convert the AC voltage received by the AC input port 134 into a second DC voltage provided to the second DC output port 137.

In this embodiment, the power supply 13 converts the AC voltage received by the AC input port 134 to generate a first DC voltage and a second DC voltage having different voltage levels provided to the main board 12, so as to meet an operating requirement of the main board 12. In an embodiment, the first DC voltage and the second DC voltage described above are 12V and 3.3V. In another embodiment, the first DC output port 136 is merely provided on the power circuit board 132 of the power supply 13 to supply the first DC voltage to the main board 12.

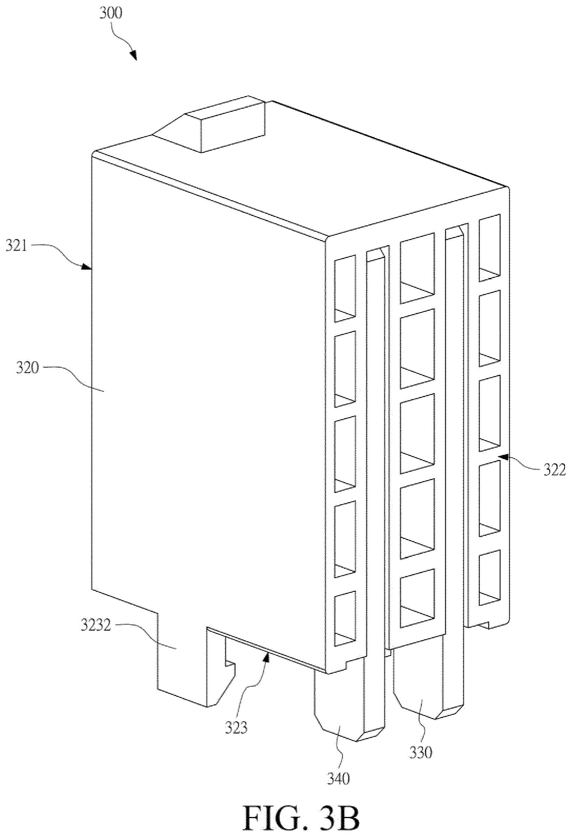

FIG. 3A and FIG. 3B are schematic diagrams of a first DC output port 300 according to an embodiment of the disclosure.

As shown in the figures, the first DC output port 300 includes a receptacle body 320, a first conductive sheet 330, a second conductive sheet 340, and a plurality of conductive pins 350.

The receptacle body 320 is defined with a horizontal direction D1 and a vertical direction D2, and includes a front surface 321, a back surface 322, and a mounting surface 323. The vertical direction D2 is a direction perpendicular to the mounting surface 323. The horizontal direction D1 is a direction parallel to the mounting surface 323 and perpendicular to the front surface 321. The front surface 321 and the back surface 322 are located on two opposite sides of the receptacle body 320. The mounting surface 323 is adjacent to the front surface 321.

A plurality of sockets 324 extending along the horizontal direction D1 is formed on the front surface 321 of the receptacle body 320. In an embodiment, as shown in the figures, eight sockets 324 are formed on the front surface 321. The eight sockets 324 are arranged in two rows along the vertical direction D2 on the front surface 321 of the receptacle body 320.

The back surface 322 of the receptacle body 320 is provided with the first conductive sheet 330 and the second conductive sheet 340. As shown in the figures, the first conductive sheet 330 and the second conductive sheet 340 are arranged side by side on the back surface 322, and extend along the vertical direction D2 and protrude from the mounting surface 323.

The plurality of conductive pins 350 is arranged on the first conductive sheet 330 and the second conductive sheet 340, and respectively extends into the plurality of sockets 324. A quantity of the conductive pins 350 is the same as a quantity of the sockets 324, and an extension direction of each of the conductive pins 350 is parallel to the horizontal direction D1.

A plurality of engaging structures 3232 is arranged on the mounting surface 323 of the receptacle body 320, so as to facilitate the receptacle body 320 to be temporarily fixed to the power circuit board 132 by engaging, and then fixed by soldering.

In this embodiment, eight sockets 324 are formed on the front surface 321 of the receptacle body 320. The sockets are arranged in two rows along the vertical direction D2 on the front surface 321 of the receptacle body 320. The sockets 324 in the same row corresponds to the same input/output potential. According to an actual requirement, such as a specification of a power line, a magnitude of a current, and presence or absence of a control signal, another quantity of the sockets 324 is arranged on the front surface 321 of the receptacle body 320. The sockets 324 also need not be arranged in two rows along the vertical direction D2. In an embodiment, the sockets 324 are arranged in three or more rows. The sockets 324 in the same row correspond to the same input/output signal (or potential).

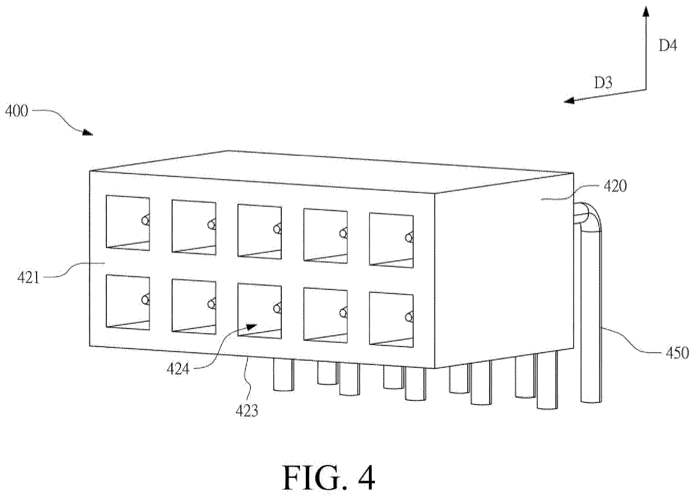

FIG. 4 is a schematic diagram of a second DC output port 400 according to an embodiment of the disclosure.

As shown in the figure, the second DC output port 400 includes a receptacle body 420 and a plurality of L-shaped conductive pins 450.

The receptacle body 420 is defined with a horizontal direction D3 and a vertical direction D4, and includes a front surface 421 and a mounting surface 423. The vertical direction D4 is a direction perpendicular to the mounting surface 423. The horizontal direction D3 is a direction parallel to the mounting surface 423 and perpendicular to the front surface 421. The mounting surface 423 is adjacent to the front surface 421.

A plurality of sockets 424 extending along the horizontal direction D3 is formed on the front surface 421 of the receptacle body 420. The plurality of L-shaped conductive pins 450 is arranged to extend through the receptacle body 420. The L-shaped conductive pins 450 extend into the plurality of sockets 424 from the mounting surface 423.

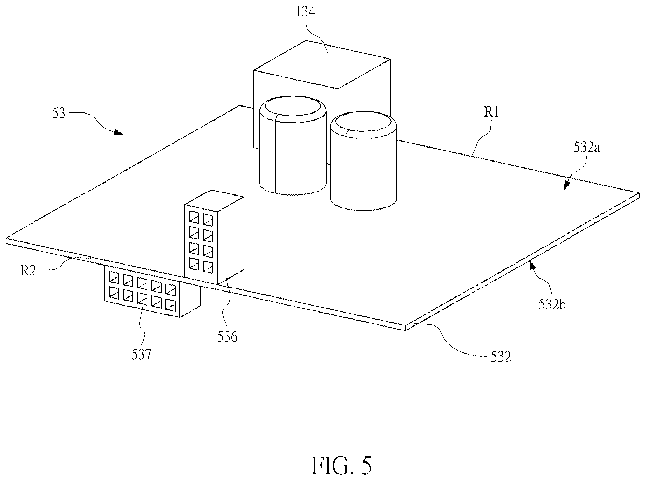

FIG. 5 is a schematic diagram of a power supply 53 according to another embodiment of the disclosure.

As shown in the figure, the power circuit board 532 includes an upper surface 532a and a lower surface 532b opposite to each other. The first DC output port 536 is provided on the upper surface 532a. The second DC output port 537 is provided on the lower surface 532b.

Compared with the power supply 13 shown in FIG. 2, the first DC output port 136 and the second DC output port 137 are both provided on the upper surface of the power circuit board 132. In this embodiment, the power supply 53 provides the first DC output port 536 on the upper surface 532a of the power circuit board 532 corresponding to the second side edge R2, and provides the second DC output port 537 on the lower surface 532b of the power circuit board 532 corresponding to the second side edge R2. In this way, a width of the second side edge R2 of the power circuit board 532 is prevented from being limited by the DC output ports, thereby helping reduce a size of the power supply 53.

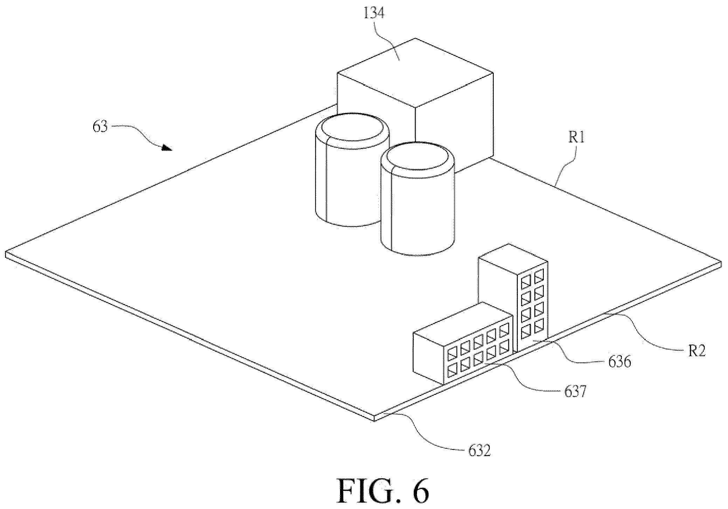

FIG. 6 is a schematic diagram of a power supply 63 according to yet another embodiment of the disclosure.

Compared with the power supply 13 shown in FIG. 2, the AC input port 136, the first DC output port 136, and the second DC output port 137 are provided on two opposite side edges of the power circuit board 132. However, the first side edge R1 and the second side edge R2 of the power circuit board 632 in this embodiment are provided on two adjacent side edges of the power circuit board 632. In other words, the AC input port 134, the first DC output port 636, and the second DC output port 637 in this embodiment are provided on two adjacent side edges of the power circuit board 632. The arrangement manner is adapted to different configuration requirements of the computer host 10. In an embodiment, the power supply 63 in this embodiment is suitable for matching with the chassis 11 where the power opening 112 is located on the side panel.

Compared to prior art, the disclosure has the following advantages. Firstly, the first DC output port 136 of the power supply 13, 53 and 63 in the disclosure is directly fixed to the power circuit board 132, 532, and 632 by soldering, which helps reduce materials and assembly procedures, thereby improving reliability of power output. Secondly, the assembly manner of the first DC output port 136 is applicable to an existing surface mount technology (SMT) process, which helps save labor costs and improve production efficiency.

The above is merely preferred embodiments of the disclosure, and does not impose any limitation on the disclosure. Any form of change such as an equivalent replacement or modification made by any person skilled in the art to technical means and technical content provided in the disclosure without departing from scope of the technical means of the disclosure is content that does not deviate from the technical means of the disclosure, and still falls within protection scope of the disclosure.

## Claims

1. A computer host (10), comprising:
a chassis (11), comprising a power opening (112);
a main board (12), arranged in the chassis (11); and
a power supply (13), arranged in the chassis (11), comprising:
a power circuit board (132), comprising a first side edge (R1) and a second side edge (R2);
an alternating current (AC) input port (134), provided on the first side edge (R1) of the power circuit board (132) and exposed to outside of the chassis (11) through the power opening (112);
a first direct current (DC) output port (136), provided on the second side edge (R2) of the power circuit board (132) and electrically connected to the main board (12) through a first power line (142), wherein an opening direction of the first DC output port (136) is parallel to a surface of the power circuit board (132); and
a conversion circuit (138), arranged on the power circuit board (132) and electrically connected to the AC input port (134) and the first DC output port (136), and adapted to convert an AC voltage received by the AC input port (134) into a first DC voltage provided to the first DC output port (136).

2. The computer host according to claim 1, wherein an outer edge of an opening of the first DC output port (136) is flush with the second side edge (R2).

3. The computer host according to claim 1, wherein the first DC output port (136) comprises:
a receptacle body (320), defined with a horizontal direction (D1) and a vertical direction (D2), wherein the receptacle body (320) comprises a front surface (321), a back surface (322), and a mounting surface (323), and a plurality of sockets extending along the horizontal direction (D1) is formed on the front surface (321);
a first conductive sheet (330) and a second conductive sheet (340), arranged side by side on the back surface (322), and extending along the vertical direction (D2) and protruding from the mounting surface (323); and
a plurality of conductive pins (350), arranged on the first conductive sheet (330) and the second conductive sheet (340), and respectively extending into the plurality of sockets (324).

4. The computer host according to claim 1, wherein the power supply (13) further comprises a second DC output port (400), the second DC output port (400) is provided on the second side edge (R2) of the power circuit board (132) and electrically connected to the main board (12) through a second power line (144), a direction of an opening of the second DC output port (400) is parallel to the surface of the power circuit board (132), and an outer edge of the opening of the second DC output port (400) is flush with the second side edge (R2).

5. The computer host according to claim 4, wherein the conversion circuit (138) is adapted to convert the AC voltage received by the AC input port (134) into a second DC voltage provided to the second DC output port (400), and the first DC voltage is different from the second DC voltage.

6. The computer host according to claim 4, wherein the second DC output port (400) comprises:
a receptacle body (320), defined with a horizontal direction (D1) and a vertical direction (D2), wherein the receptacle body (320) comprises a front surface (321) and a mounting surface (323), and a plurality of sockets (324) extending along the horizontal direction (D1) is formed on the front surface (321); and
a plurality of L-shaped conductive pins (350), arranged to extend through the receptacle body (320), wherein the plurality of L-shaped conductive pins (350) respectively extends from the mounting surface (323) into the plurality of sockets (324).

7. The computer host according to claim 4, wherein the power circuit board (132) comprises an upper surface (532a) and a lower surface (532b) opposite to each other, the first DC output port (136) is provided on the upper surface (532a), and the second DC output port (400) is provided on the lower surface (532b).

8. The computer host according to claim 4, wherein the first DC output port (136) and the second DC output port (400) are provided side by side on the second side edge (R2) of the power circuit board (132).

9. The computer host according to claim 1, wherein the first side edge (R1) and the second side edge (R2) are located on two opposite sides of the power circuit board (132).

10. The computer host according to claim 1, wherein the first side edge (R1) and the second side edge (R2) are located on two adjacent sides of the power circuit board (132).

11. The computer host according to claim 1, wherein the power opening (112) is located on a rear panel of the chassis (11), and the first side edge (R1) abuts against the rear panel.

## Amended claims

### Amended claims in accordance with Rule 137(2) EPC.

1. A computer host (10), comprising:
a chassis (11), comprising a power opening (112);
a main board (12), arranged in the chassis (11); and
a power supply (13), arranged in the chassis (11), comprising:
a power circuit board (132), comprising a first side edge (R1) and a second side edge (R2);
an alternating current, AC, input port (134), provided on the first side edge (R1) of the power circuit board (132) and exposed to outside of the chassis (11) through the power opening (112);
a first direct current, DC, output port (136), provided on the second side edge (R2) of the power circuit board (132) and electrically connected to the main board (12) through a first power line (142), wherein an opening direction of the first DC output port (136) is parallel to a surface of the power circuit board (132); and
a conversion circuit (138), arranged on the power circuit board (132) and electrically connected to the AC input port (134) and the first DC output port (136), and adapted to convert an AC voltage received by the AC input port (134) into a first DC voltage provided to the first DC output port (136),
wherein the first DC output port (136) comprises: a receptacle body (320), defined with a horizontal direction (D1) and a vertical direction (D2), wherein the receptacle body (320) comprises a front surface (321), a back surface (322), and a mounting surface (323), and a plurality of sockets extending along the horizontal direction (D1) is formed on the front surface (321); a first conductive sheet (330) and a second conductive sheet (340), arranged side by side on the back surface (322), and extending along the vertical direction (D2) and protruding from the mounting surface (323); and a plurality of conductive pins (350), arranged on the first conductive sheet (330) and the second conductive sheet (340), and respectively extending into the plurality of sockets (324).

2. The computer host according to claim 1, wherein an outer edge of an opening of the first DC output port (136) is flush with the second side edge (R2).

3. The computer host according to claim 1, wherein the power supply (13) further comprises a second DC output port (400), the second DC output port (400) is provided on the second side edge (R2) of the power circuit board (132) and electrically connected to the main board (12) through a second power line (144), a direction of an opening of the second DC output port (400) is parallel to the surface of the power circuit board (132), and an outer edge of the opening of the second DC output port (400) is flush with the second side edge (R2).

4. The computer host according to claim 3, wherein the conversion circuit (138) is adapted to convert the AC voltage received by the AC input port (134) into a second DC voltage provided to the second DC output port (400), and the first DC voltage is different from the second DC voltage.

5. The computer host according to claim 3, wherein the second DC output port (400) comprises:
a receptacle body (320), defined with a horizontal direction (D1) and a vertical direction (D2), wherein the receptacle body (320) comprises a front surface (321) and a mounting surface (323), and a plurality of sockets (324) extending along the horizontal direction (D1) is formed on the front surface (321); and
a plurality of L-shaped conductive pins (350), arranged to extend through the receptacle body (320), wherein the plurality of L-shaped conductive pins (350) respectively extends from the mounting surface (323) into the plurality of sockets (324).

6. The computer host according to claim 3, wherein the power circuit board (132) comprises an upper surface (532a) and a lower surface (532b) opposite to each other, the first DC output port (136) is provided on the upper surface (532a), and the second DC output port (400) is provided on the lower surface (532b).

7. The computer host according to claim 3, wherein the first DC output port (136) and the second DC output port (400) are provided side by side on the second side edge (R2) of the power circuit board (132).

8. The computer host according to claim 1, wherein the first side edge (R1) and the second side edge (R2) are located on two opposite sides of the power circuit board (132).

9. The computer host according to claim 1, wherein the first side edge (R1) and the second side edge (R2) are located on two adjacent sides of the power circuit board (132).

10. The computer host according to claim 1, wherein the power opening (112) is located on a rear panel of the chassis (11), and the first side edge (R1) abuts against the rear panel.
